# EUROPEAN PATENT SPECIFICATION

(11) **EP 4 099 415 B1**
(45) Date of publication and mention of the grant of the patent: **04.11.2026**
(21) Application number: 21747988.0
(22) Date of filing: 12.01.2021
(51) Int. Cl.: H10K 30/40, H10K 71/50, H10K 30/81, H10K 85/20, H10K 30/15, H10K 30/20, H10K 30/50, H10K 71/15, H10K 85/50

(54) **PHOTOELECTRIC CONVERSION ELEMENT AND METHOD FOR MANUFACTURING SAME**
PHOTOELEKTRISCHES WANDLERELEMENT UND VERFAHREN ZU SEINER HERSTELLUNG
ÉLÉMENT DE CONVERSION PHOTOÉLECTRIQUE ET SON PROCÉDÉ DE FABRICATION

(30) Priority: 31.01.2020 JP 2020015666; 31.01.2020 JP 2020015669
(43) Date of publication of application: 07.12.2022
(73) Proprietor: Zeon Corporation, Tokyo 100-8246 (JP)
(72) Inventor: KOMIYA, Ryoichi, Tokyo 100-8246 (JP)
(74) Representative: Maiwald GmbH
(86) International application number: PCT/JP2021/000699
(87) International publication number: WO 2021/153218

(56) References cited:
- EP-A1- 3 064 472
- WO-A1-2018/159638
- WO-A1-2018/229765
- WO-A1-2018/229765
- JP-A- 2010 506 824
- JP-A- 2017 216 449
- US-A1- 2010 272 981
- US-A1- 2019 122 830
- YONG HYUN KIM ET AL: "Semi-transparent small molecule organic solar cells with laminated free-standing carbon nanotube top electrodes", SOLAR ENERGY MATERIALS AND SOLAR CELLS, ELSEVIER SCIENCE PUBLISHERS, AMSTERDAM, NL, vol. 96, no. 1, 2 October 2011 (2011-10-02), pages 244 - 250, XP028106118, ISSN: 0927-0248, [retrieved on 20111010], DOI: 10.1016/J.SOLMAT.2011.10.001

## Description

### TECHNICAL FIELD

The present disclosure relates to a photoelectric conversion element and a method of producing the same.

### BACKGROUND

Solar cells are of interest as photoelectric conversion elements that convert light energy to electrical power. There are various types of solar cells such as perovskite solar cells in which a perovskite compound is used as a power-generating layer, for example. Numerous studies have been made in recent years with the aim of increasing the photoelectric conversion efficiency of photoelectric conversion elements and solar cells.

As one example, Patent Literature (PTL) 1 proposes a solar cell including a composite self-supporting film that is flexible and that includes a flexible structure retention layer containing a fibrous and/or nanotube-like structural material and a semiconductor layer formed on the surface of the structure retention layer.

As another example, PTL 2 proposes a solid junction-type photoelectric conversion element that includes a substrate, a first conductive layer, and a conductive material including a perovskite layer in this order and in which the conductive material is self-supporting.

As yet another example, Non-Patent Literature (NPL) 1 proposes a perovskite solar cell that includes single-walled carbon nanotubes with a thickness of approximately 100 nm on a perovskite film. Free-standing porous carbon nanotube sheets have been disclosed in NPL2 and PTL3. A solar cell with a porous carbon electrode that comprises perovskite material is known from PTL4.

### CITATION LIST

### Patent Literature

PTL 1: JP2015-185836A
PTL 2: WO2017/142074A1 PTL3: WO 2018/229765 A1
PTL4: US 2019/122830 A1

### Non-Patent Literature

NPL 1: Sakaguchi et al., "Non-doped and unsorted single-walled carbon nanotubes as carrier-selective, transparent, and conductive electrode for perovskite solar cells", MRS Communications (2018), 8, p.1058-1063, Materials Research Society, 2018
NPL2: YONG HYUN KIM ET AL: "Semi-transparent small molecule organic solar cells with laminated free-standing carbon nanotube top electrodes", SOLAR ENERGY MATERIALS AND SOLAR CELLS (2011), vol. 96, no. 1, pages 244-250

### SUMMARY

### (Technical Problem)

However, there is room for improvement of conventional photoelectric conversion elements in terms of displaying excellent photoelectric conversion efficiency and being easy to produce.

Accordingly, an object of the present disclosure is to provide a photoelectric conversion element that displays excellent photoelectric conversion efficiency and is easy to produce and a method of producing this photoelectric conversion element.

### (Solution to Problem)

The inventor conducted diligent investigation with the aim of solving the problem set forth above. The inventor discovered that by providing a porous self-supporting sheet containing at least single-walled carbon nanotubes on a power-generating layer of a photoelectric conversion element, it is possible to cause the porous self-supporting sheet to display functionality as a hole transport layer and functionality as a current-collecting electrode, and that the resultant photoelectric conversion element displays excellent photoelectric conversion efficiency and is easy to produce. In this manner, the inventor completed the present disclosure.

Specifically, the present disclosure aims to advantageously solve the problem set forth above, and a presently disclosed photoelectric conversion element comprises a unified laminate that includes, in stated order, a light-transmitting base plate, a transparent conductive film, a first conductive layer, a power-generating layer, and a second conductive layer, wherein the second conductive layer is formed of a porous self-supporting sheet that at least contains one or more single-walled carbon nanotubes. The porous self-supporting sheet contains a constituent material of the power-generating layer or at least part of a constituent material of the power-generating layer. Through a photoelectric conversion element that includes a unified laminate including a light-transmitting base plate, a transparent conductive film, a first conductive layer, a power-generating layer, and a second conductive layer in stated order and in which the second conductive layer is formed of a porous self-supporting sheet containing at least single-walled carbon nanotubes in this manner, it is possible to provide a photoelectric conversion element that displays excellent photoelectric conversion efficiency and is easy to produce.

Note that the term "porous self-supporting sheet" as used in the present disclosure refers to a sheet that has a plurality of pores formed therein and that can maintain its shape as a sheet without a support. The porous self-supporting sheet that is used herein does not experience sheet tearing or the like and maintains its shape as a sheet even when the porous self-supporting sheet is immersed in a specific solution, is pulled up from the solution, and is subsequently affixed to an adherend. Moreover, the porous self-supporting sheet used herein does not experience sheet tearing or deformation even in a situation in which chlorobenzene or the like, which is a poor solvent for a perovskite compound, is dripped onto the sheet or in a situation in which the porous self-supporting sheet is handled using a jig that is used for affixing of the sheet, for example. The porous self-supporting sheet used herein preferably maintains its shape as a sheet without a support when of a size of 1 µm to 200 µm in thickness and 1 mm² to 100 cm² in area, for example.

In the presently disclosed photoelectric conversion element, a joining layer may be included in at least part of between the power-generating layer and the second conductive layer, and the joining layer may be formed of an organic material A and have a different composition and property to the power-generating layer and the second conductive layer. Through a photoelectric conversion element that includes a unified laminate including a light-transmitting base plate, a transparent conductive film, a first conductive layer, a power-generating layer, and a second conductive layer in stated order, in which the second conductive layer is formed of a porous self-supporting sheet containing at least single-walled carbon nanotubes, in which a joining layer is included in at least part of between the power-generating layer and the second conductive layer, and in which the joining layer is formed of an organic material A and has a different composition and property to the power-generating layer and the second conductive layer in this manner, it is possible to provide a photoelectric conversion element that displays excellent photoelectric conversion efficiency and is easy to produce.

In the presently disclosed photoelectric conversion element, the porous self-supporting sheet may contain the organic material A. When the porous self-supporting sheet contains the organic material A, photoelectric conversion efficiency can be increased because transfer of charge between the power-generating layer and the second conductive layer can be performed well.

In the presently disclosed photoelectric conversion element, it is normally preferable that the porous self-supporting sheet has a thickness of 20 µm or more. When the thickness of the porous self-supporting sheet is 20 µm or more, it is possible to sufficiently impart functionality as a current-collecting electrode to the second conductive layer.

In accordance with the claimed invention, the porous self-supporting sheet contains a constituent material of the power-generating layer or at least part of a constituent material of the power-generating layer. When the porous self-supporting sheet contains a constituent material of the power-generating layer or at least part of a constituent material of the power-generating layer, photoelectric conversion efficiency can be increased because transfer of charge between the power-generating layer and the second conductive layer can be performed well.

In the presently disclosed photoelectric conversion element, the power-generating layer preferably contains a perovskite compound. By using a power-generating layer that contains a perovskite compound, production cost of the photoelectric conversion element can be reduced, and ease of production of the photoelectric conversion element can be improved.

In the presently disclosed photoelectric conversion element, the single-walled carbon nanotubes preferably have an average diameter (Av) and a diameter standard deviation (σ) satisfying a relationship: 0.20 < (3σ/Av) < 0.60. By using single-walled carbon nanotubes that satisfy the above relationship, photoelectric conversion efficiency can be further increased.

Note that the "average diameter (Av) of carbon nanotubes" and "diameter standard deviation (σ: standard deviation) of carbon nanotubes" can be determined by measuring the diameters (external diameters) of 100 randomly selected single-walled CNTs using a transmission electron microscope. Also note that the average diameter (Av) and standard deviation (σ) of the single-walled CNTs may be adjusted by altering the production method and/or production conditions of the single-walled CNTs, or may be adjusted by combining a plurality of types of single-walled CNTs obtained by different production methods.

In the presently disclosed photoelectric conversion element, the single-walled carbon nanotubes preferably exhibit a convex upward shape in a t-plot obtained from an adsorption isotherm. By using single-walled carbon nanotubes that exhibit a convex upward shape in a t-plot, it is possible to produce a more stable porous self-supporting sheet and to stably produce a photoelectric conversion element.

In the presently disclosed photoelectric conversion element, the first conductive layer preferably contains either or both of a metal oxide and an organic compound. By using a first conductive layer that contains a metal oxide and/or organic compound having an optimal energy level relative to an energy level of a power-generating layer that contains a perovskite compound such as described above, for example, it is possible to further improve performance of the photoelectric conversion element.

Moreover, the present disclosure aims to advantageously solve the problem set forth above, and a presently disclosed method of producing a photoelectric conversion element is a method of producing any one of the photoelectric conversion elements set forth above, comprising a step of stacking the porous self-supporting sheet on the power-generating layer in a state in which a joining surface of at least one of the power-generating layer and the porous self-supporting sheet retains a solvent or a solution. By stacking the porous self-supporting sheet on the power-generating layer in a state in which a joining surface of at least one of the power-generating layer and the porous self-supporting sheet retains a solvent or a solution, it is easy to produce a photoelectric conversion element that displays excellent photoelectric conversion efficiency.

In the presently disclosed method of producing a photoelectric conversion element, the solvent may be a poor solvent, and the porous self-supporting sheet that is stacked on the power-generating layer may be impregnated with the solvent. Through this configuration, the porous self-supporting sheet can be affixed well to the power-generating layer.

In the presently disclosed method of producing a photoelectric conversion element, the power-generating layer may be a layer that is formed of a perovskite compound, the solution may be a solution having at least one perovskite compound precursor dissolved in a poor solvent, and the porous self-supporting sheet that is stacked on the power-generating layer may be impregnated with the solution. Through this configuration, transfer of charge between the power-generating layer and the second conductive layer can be performed efficiently in the resultant photoelectric conversion element because a porous self-supporting sheet containing at least one perovskite compound precursor is stacked on the power-generating layer, and, as a result, photoelectric conversion efficiency of the photoelectric conversion element improves.

In the presently disclosed method of producing a photoelectric conversion element, the solution may be an organic material-containing solution having the organic material A dissolved in a poor solvent, and the porous self-supporting sheet that is stacked on the power-generating layer may be impregnated with the organic material-containing solution. Through this configuration, the porous self-supporting sheet can be affixed well to the power-generating layer.

The presently disclosed method of producing a photoelectric conversion element preferably further comprises a step of heat pressing the porous self-supporting sheet that has been stacked on the power-generating layer. Through this configuration, a photoelectric conversion element having excellent unity can be obtained.

### (Advantageous Effect)

According to the present disclosure, it is possible to provide a photoelectric conversion element that displays excellent photoelectric conversion efficiency and is easy to produce and a method of producing this photoelectric conversion element.

### BRIEF DESCRIPTION OF THE DRAWINGS

In the accompanying drawings:
FIG. 1 is a cross-sectional view schematically illustrating the configuration of a photoelectric conversion element according to one embodiment of the present disclosure; and
FIG. 2 is a cross-sectional view schematically illustrating the configuration of a photoelectric conversion element according to a modified example of an embodiment of the present disclosure.

### DETAILED DESCRIPTION

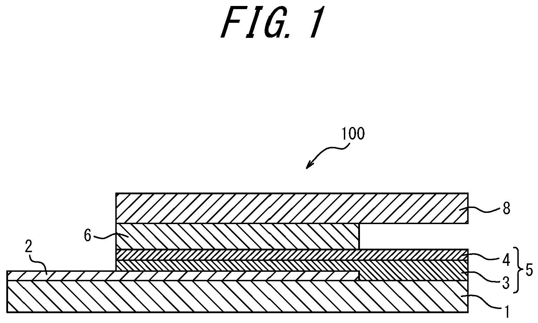

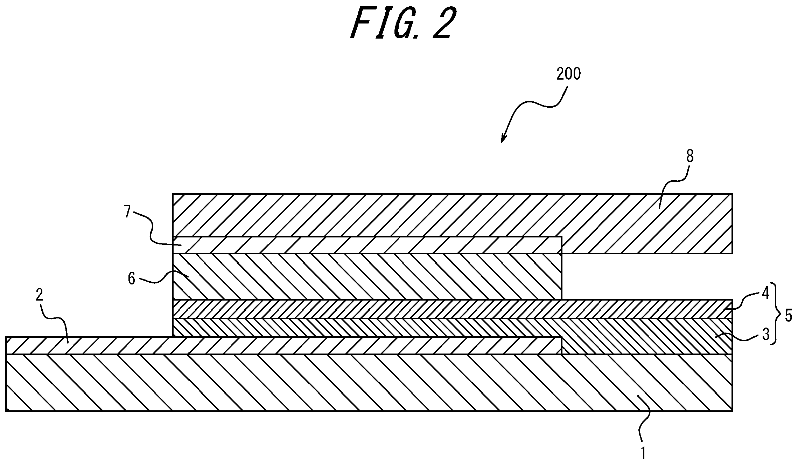

The presently disclosed photoelectric conversion element can be used as a perovskite solar cell, for example, but is not specifically limited to being used in this manner. The following provides a detailed description of one embodiment of the presently disclosed photoelectric conversion element and a modified example thereof with reference to FIG. 1 and FIG. 2.

### (Photoelectric conversion element)

FIG. 1 is a cross-sectional view schematically illustrating the configuration of a photoelectric conversion element according to one embodiment of the present disclosure. The photoelectric conversion element 100 includes a unified laminate that includes, in stated order: a light-transmitting base plate 1; a transparent conductive film 2; a first conductive layer 5 formed of a base layer 3 and a porous semiconductor layer 4; a power-generating layer 6; and a second conductive layer 8. The second conductive layer 8 is formed of a porous self-supporting sheet that at least contains one or more single-walled carbon nanotubes (hereinafter, referred to as "single-walled CNTs"). The porous self-supporting sheet contains a constituent material of the power-generating layer or at least part of a constituent material of the power-generating layer.

The following describes, in order, the various constituent members forming the photoelectric conversion element 100.

### <Light-transmitting base plate 1>

The light-transmitting base plate 1 constitutes a substrate of the photoelectric conversion element 100. The light-transmitting base plate 1 may be a base plate formed of glass or a synthetic resin, a film formed of a synthetic resin, or the like, for example, without any specific limitations.

Examples of glass that may form the light-transmitting base plate 1 include glass made of an inorganic substance such as soda glass.

Examples of synthetic resins that may form the light-transmitting base plate 1 include polyacrylic resin, polycarbonate resin, polyester resin, polyimide resin, polystyrene resin, polyvinyl chloride resin, polyamide resin, and polycycloolefin resin. Of these examples, polyethylene terephthalate (PET) and polyethylene naphthalate (PEN) are preferable as synthetic resins from a viewpoint of obtaining a photoelectric conversion element 100 that is thin, light, and flexible.

The thickness of the light-transmitting base plate 1 is not specifically limited and may be any thickness that makes it possible to maintain the shape thereof as a base plate. For example, the thickness of the light-transmitting base plate 1 can be set as not less than 0.1 mm and not more than 10 mm.

### <Transparent conductive film 2>

The transparent conductive film 2 is a film formed of a metal oxide that is formed on the surface of the light-transmitting base plate 1. By providing the transparent conductive film 2, it is possible to impart electrical conductivity to the surface of the light-transmitting base plate 1.

The metal oxide forming the transparent conductive film 2 may be fluorine-doped tin oxide (FTO), tin oxide (SnO), indium oxide (In₂O₃), tin-doped indium oxide (ITO), zinc oxide (ZnO), indium oxide/zinc oxide (IZO), gallium oxide/zinc oxide (GZO), or the like, for example. Note that although one transparent conductive film 2 is present on the light-transmitting base plate 1 in the photoelectric conversion element 100 illustrated in FIG. 1, two or more transparent conductive films 2 may be present on the light-transmitting base plate 1. In a case in which the photoelectric conversion element 100 includes two or more transparent conductive films 2, these transparent conductive films may be formed of the same metal oxide or may be formed of different metal oxides to one another.

The thickness of the transparent conductive film 2 is not specifically limited so long as it is a thickness that can impart the desired electrical conductivity to the light-transmitting base plate 1 and can, for example, be set as not less than 1 nm and not more than 1 µm. Note that the transparent conductive film 2 may be formed over the entire surface of the light-transmitting base plate 1 or may be formed on part of the surface of the light-transmitting base plate 1 as illustrated in FIG. 1.

### <First conductive layer 5>

The first conductive layer 5 is a layer that functions as a charge transport layer and that is formed of an n-type semiconductor. In the present embodiment, the first conductive layer 5 is formed of two layers: a base layer 3 and a porous semiconductor layer 4. However, the first conductive layer 5 is not limited to this configuration and may be a single layer that is formed of an n-type semiconductor.

### <Base layer 3>

The base layer 3 is an optionally provided layer. Through provision of the base layer 3, direct contact of the light-transmitting base plate 1 or the transparent conductive film 2 with the porous semiconductor layer 4 is prevented. This prevents loss of electromotive force and thereby improves the photoelectric conversion efficiency of the photoelectric conversion element 100.

The base layer 3 may be a porous film or may be a non-porous dense film, for example, so long as it is formed of an n-type semiconductor. However, the base layer 3 is preferably a non-porous dense film from a viewpoint of sufficiently preventing contact of the light-transmitting base plate 1 or the transparent conductive film 2 with the porous semiconductor layer 4. The thickness of the base layer 3 is not specifically limited and can, for example, be set as not less than 1 nm and not more than 500 nm. The base layer 3 may optionally contain an electrically insulating material other than the n-type semiconductor in a proportion that does not cause the loss of character of the base layer 3 as an n-type semiconductor.

### <Porous semiconductor layer 4>

The porous semiconductor layer 4 is a layer having a porous form. The inclusion of the porous semiconductor layer 4 in the first conductive layer 5 can further improve the photoelectric conversion efficiency of the photoelectric conversion element 100.

The porous semiconductor layer 4 preferably contains a metal oxide and/or an organic compound, more preferably contains fine particles formed of a metal oxide and/or an organic compound, and is even more preferably formed from fine particles formed of a metal oxide and/or an organic compound.

The metal oxide that may form the porous semiconductor layer 4 is not specifically limited so long as it is a metal oxide that functions as an n-type semiconductor and may be titanium oxide (TiO₂), for example.

The organic compound that may form the porous semiconductor layer 4 may be a fullerene derivative such as phenyl C61 butyric acid methyl ester (PCBM), for example.

The particle diameter (average particle diameter of primary particles) of fine particles of a metal oxide and/or an organic compound that may be used in the porous semiconductor layer 4 is preferably not less than 2 nm and not more than 80 nm, and more preferably 30 nm or less. A smaller particle diameter can reduce the resistance of the porous semiconductor layer 4. The fine particles may be particles of the same particle diameter used by themselves or may be particles of different particle diameters used in combination. Note that the average particle diameter of the fine particles can be determined by measuring the particle diameters of 100 randomly selected fine particles using an electron microscope.

The thickness of the porous semiconductor layer 4 is not specifically limited but is normally 5 nm or more, and preferably 10 nm or more, and is normally 500 nm or less, and preferably 100 nm or less. The porous semiconductor layer 4 may be formed of one layer as illustrated in FIG. 1 or may be formed of a plurality of layers.

### <Power-generating layer 6>

The power-generating layer 6 is a layer that is formed of a material that generates electromotive force through absorption of light, is preferably a layer that contains a perovskite compound, and is more preferably a layer (perovskite layer) that is formed of a perovskite compound.

Examples of perovskite compounds that may form the power-generating layer 6 include commonly known perovskite compounds without any specific limitations. More specifically, the perovskite compound may be CH₃NH₃PbI₃, CH₃NH₃PbBr₃, (CH₃(CH₂)ₙCHCH₃NH₃)₂PbI₄ [n = 5 to 8], (C₆H₅C₂H₄NH₃)₂PbBr₄, or the like, for example.

The thickness of the power-generating layer 6 is not specifically limited but is preferably 100 nm or more, and more preferably 200 nm or more, and is preferably 1 µm or less, and more preferably 800 nm or less. By setting the thickness of the power-generating layer 6 as 100 nm or more, electromotive force of the power-generating layer 6 can be increased.

### <Second conductive layer 8>

The second conductive layer 8 is a layer that is formed of a porous self-supporting sheet. The porous self-supporting sheet is required to at least contain one or more single-walled CNTs, is preferably a sheet formed of single-walled CNTs, and is more preferably a sheet formed of buckypaper. By using a porous self-supporting sheet that at least contains single-walled CNTs, it is possible to impart excellent functionality as a hole transport layer and functionality as a current-collecting electrode to the second conductive layer 8.

### <<Porous self-supporting sheet>>

The single-walled CNTs contained in the porous self-supporting sheet preferably include single-walled CNTs having the following properties.

### -(3σ/Av)-

A ratio (3σ/Av) of a value (3σ), which is obtained by multiplying the diameter standard deviation (σ) of the single-walled CNTs contained in the porous self-supporting sheet by 3, relative to the average diameter (Av) of the single-walled CNTs, is preferably more than 0.20, more preferably more than 0.25, and even more preferably more then 0.50, and is preferably less than 0.60. When 3σ/Av is more than 0.20 and less than 0.60, it is possible to impart sufficient functionality as a hole transport layer and functionality as a current-collecting electrode to the second conductive layer 8 even when the porous self-supporting sheet only contains a small amount of the single-walled CNTs.

### -Average diameter (Av) of single-walled CNTs-

The average diameter (Av) of the single-walled CNTs is preferably 0.5 nm or more, and more preferably 1 nm or more, and is preferably 15 nm or less, and more preferably 10 nm or less. When the average diameter (Av) of the single-walled CNTs is 0.5 nm or more, aggregation of the single-walled CNTs can be inhibited, and dispersibility of the single-walled CNTs in the second conductive layer 8 can be increased. Moreover, when the average diameter (Av) of the single-walled CNTs is 15 nm or less, the second conductive layer 8 can sufficiently display functionality as a current-collecting electrode.

### -t-Plot-

The single-walled CNTs preferably exhibit a convex upward shape in a t-plot obtained from an adsorption isotherm. These single-walled CNTs are more preferably single-walled CNTs that have not undergone opening formation treatment. By using single-walled CNTs that exhibit a convex upward shape in a t-plot obtained from an adsorption isotherm, it is possible to obtain a second conductive layer 8 having excellent strength.

A bending point of the t-plot for the single-walled CNTs is preferably within a range of 0.2 ≤ t (nm) ≤ 1.5, more preferably within a range of 0.45 ≤ t (nm) ≤ 1.5, and even more preferably within a range of 0.55 ≤ t (nm) ≤ 1.0.

Measurement of an adsorption isotherm for single-walled CNTs, preparation of a t-plot, and analysis of the t-plot can be performed using a BELSORP^{®}-mini (BELSORP is a registered trademark in Japan, other countries, or both), for example, which is a commercially available measurement apparatus produced by Bel Japan Inc.

Single-walled CNTs having the properties set forth above can be efficiently produced by, in the super growth method (refer to WO2006/011655A1), forming a catalyst layer at the surface of a substrate by a wet process, for example, but are not specifically limited to being produced in this manner. Note that the super growth method is a method in which, during synthesis of CNTs through chemical vapor deposition (CVD) by supplying a feedstock compound and a carrier gas onto a substrate having a catalyst layer for CNT production at the surface thereof, a trace amount of an oxidant (catalyst activating material) is provided in the system so as to dramatically improve the catalytic activity of the catalyst layer.

In particular, single-walled CNTs obtained by the super growth method are preferably used as the single-walled CNTs from a viewpoint of easily obtaining a porous self-supporting sheet having a large thickness.

The porous self-supporting sheet also contains a constituent material of the previously described power-generating layer 6 or part of a constituent material of the power-generating layer 6. More specifically, the porous self-supporting sheet may include a constituent material of the power-generating layer 6 or part of a constituent material of the power-generating layer inside a plurality of pores of the porous self-supporting sheet.

The proportion constituted by the single-walled CNTs contained in the porous self-supporting sheet is not specifically limited but is preferably 50 mass% or more, and is preferably 75 mass% or more.

Examples of materials other than the single-walled CNTs that can optionally be contained in the porous self-supporting sheet include an organic material or inorganic material serving as a p-type semiconductor and fibrous carbon nanostructures other than single-walled CNTs.

Examples of organic materials that can be contained in the porous self-supporting sheet include 2,2',7,7'-tetrakis(N,N-di-p-methoxyphenylamino)-9,9'-spirobifluorene (spiro-MeOTAD), poly(3-hexylthiophene) (P3HT), and poly(triaryl amine) (PTAA).

Examples of inorganic materials that can be contained in the porous self-supporting sheet include CuI, CuSCN, CuO, and Cu₂O.

In general, the thickness of the porous self-supporting sheet is preferably 20 µm or more, and preferably 30 µm or more, and is preferably 200 µm or less, and more preferably 80 µm or less. When the thickness of the porous self-supporting sheet is not less than 20 µm and not more than 200 µm, the second conductive layer 8 can display even better functionality as a current-collecting electrode.

### <<Production method of porous self-supporting sheet>>

No specific limitations are placed on the method by which the porous self-supporting sheet is produced. For example, a method that includes a step (film formation step) of removing a solvent from a fibrous carbon nanostructure dispersion liquid containing fibrous carbon nanostructures that at least include single-walled CNTs, a dispersant, and a solvent so as to form the porous self-supporting sheet can be adopted. The production method of the porous self-supporting sheet may, prior to the film formation step, optionally include a step (dispersion liquid production step) of performing dispersing treatment of a crude dispersion liquid containing fibrous carbon nanostructures that at least include single-walled CNTs, a dispersant, and a solvent so as to produce the aforementioned fibrous carbon nanostructure dispersion liquid.

### -Dispersion liquid production step-

In the dispersion liquid production step, a crude dispersion liquid containing fibrous carbon nanostructures that include at least single-walled CNTs, a dispersant, and a solvent is preferably subjected to dispersing treatment that brings about a cavitation effect or a crushing effect such as described in detail further below so as to disperse the fibrous carbon nanostructures including single-walled CNTs and produce a fibrous carbon nanostructure dispersion liquid, but is not specifically limited to being treated in this manner. By performing dispersing treatment that brings about a cavitation effect or a crushing effect in this manner, it is possible to obtain a fibrous carbon nanostructure dispersion liquid in which the fibrous carbon nanostructures including single-walled CNTs are dispersed well. Moreover, by producing the porous self-supporting sheet using fibrous carbon nanostructures having single-walled CNTs dispersed well, it is possible to cause uniform dispersion of the single-walled CNTs and obtain a porous self-supporting sheet having excellent characteristics such as electrical conductivity, thermal conductivity, and mechanical characteristics. Note that the fibrous carbon nanostructure dispersion liquid used to produce the porous self-supporting sheet may be produced by using commonly known dispersing treatment other than that described above to disperse fibrous carbon nanostructures including single-walled CNTs in a solvent.

The fibrous carbon nanostructures used to produce the fibrous carbon nanostructure dispersion liquid include at least single-walled CNTs and may, for example, be a mixture of single-walled CNTs and fibrous carbon nanostructures other than single-walled CNTs (for example, multi-walled CNTs, etc.).

The proportional contents of single-walled CNTs and fibrous carbon nanostructures other than single-walled CNTs in the fibrous carbon nanostructure dispersion liquid can be set as a mass ratio (single-walled CNTs/fibrous carbon nanostructures other than single-walled CNTs) of 50/50 to 75/25, for example.

### =Dispersant=

The dispersant used in production of the fibrous carbon nanostructure dispersion liquid is not specifically limited so long as it can disperse fibrous carbon nanostructures that at least include single-walled CNTs and can dissolve in the solvent that is used to produce the fibrous carbon nanostructure dispersion liquid. Examples of such dispersants include surfactants, synthetic polymers, and natural polymers.

Examples of surfactants that can be used include sodium dodecylsulfonate, sodium deoxycholate, sodium cholate, and sodium dodecylbenzenesulfonate.

Examples of synthetic polymers that can be used include polyether diols, polyester diols, polycarbonate diols, polyvinyl alcohol, partially saponified polyvinyl alcohol, acetoacetyl group-modified polyvinyl alcohol, acetal group-modified polyvinyl alcohol, butyral group-modified polyvinyl alcohol, silanol group-modified polyvinyl alcohol, ethylene-vinyl alcohol copolymers, ethylene-vinyl alcohol-vinyl acetate copolymer resins, dimethylaminoethyl acrylate, dimethylaminoethyl methacrylate, acrylic resins, epoxy resins, modified epoxy resins, phenoxy resins, modified phenoxy resins, phenoxy ether resins, phenoxy ester resins, fluororesins, melamine resins, alkyd resins, phenolic resins, polyacrylamide, polyacrylic acid, polystyrene sulfonic acid, polyethylene glycol, and polyvinyl pyrrolidone.

Examples of natural polymers that can be used include polysaccharides such as starch, pullulan, dextran, dextrin, guar gum, xanthan gum, amylose, amylopectin, alginic acid, gum Arabic, carrageenan, chondroitin sulfate, hyaluronic acid, curdlan, chitin, chitosan, cellulose, and salts and derivatives thereof. The term derivatives refers to conventionally known compounds such as esters and ethers.

One of these dispersants may be used individually, or two or more of these dispersants may be used as a mixture. Of these examples, surfactants are preferable as the dispersant due to exhibiting excellent dispersing ability toward fibrous carbon nanostructures including single-walled CNTs, and sodium deoxycholate or the like is more preferable as the dispersant.

### =Solvent=

Examples of the solvent of the fibrous carbon nanostructure dispersion liquid include, but are not specifically limited to, water, alcohols such as methanol, ethanol, n-propanol, isopropanol, n-butanol, isobutanol, t-butanol, pentanol, hexanol, heptanol, octanol, nonanol, decanol, and amyl alcohol, ketones such as acetone, methyl ethyl ketone, and cyclohexanone, esters such as ethyl acetate and butyl acetate, ethers such as diethyl ether, dioxane, and tetrahydrofuran, amide polar organic solvents such as N,N-dimethylformamide and N-methylpyrrolidone, and aromatic hydrocarbons such as toluene, xylene, chlorobenzene, orthodichlorobenzene, and paradichlorobenzene. One of these solvents may be used individually, or two or more of these solvents may be used as a mixture.

In the dispersion liquid production step, it is preferable that dispersing treatment that brings about a cavitation effect or a crushing effect such as described below is performed, for example.

### ~Dispersing treatment bringing about cavitation effect~

The dispersing treatment that brings about a cavitation effect is a dispersing method that utilizes shock waves caused by the rupture of vacuum bubbles formed in water when high energy is imparted to the liquid. This dispersing method enables good dispersion of single-walled CNTs.

Specific examples of dispersing treatments that bring about a cavitation effect include dispersing treatment using ultrasound, dispersing treatment using a jet mill, and dispersing treatment using high-shear stirring. Just one of these dispersing treatments may be carried out or a plurality of these dispersing treatments may be carried out in combination. More specifically, the use of an ultrasonic homogenizer, a jet mill, or a high-shear stirring device is preferable, for example. Commonly known conventional devices may be used as these devices.

In a situation in which the single-walled CNTs are dispersed using an ultrasonic homogenizer, the crude dispersion liquid is irradiated with ultrasound by the ultrasonic homogenizer. The irradiation time may be set as appropriate depending on the amount of the single-walled CNTs and so forth. For example, the irradiation time is preferably 3 minutes or more, and more preferably 30 minutes or more, and is preferably 5 hours or less, and more preferably 2 hours or less. Moreover, the power is preferably not less than 20 W and not more than 500 W, and more preferably not less than 100 W and not more than 500 W, for example, and the temperature is preferably not lower than 15°C and not higher than 50°C, for example.

In a situation in which a jet mill is used, the number of treatment repetitions carried out may be set as appropriate depending on the amount of CNTs and so forth. For example, the number of repetitions is preferably 2 or more, and more preferably 5 or more, and is preferably 100 or less, and more preferably 50 or less. The pressure is preferably not less than 20 MPa and not more than 250 MPa, for example, and the temperature is preferably not lower than 15°C and not higher than 50°C, for example.

**In** a situation in which high-shear stirring is used, the crude dispersion liquid is subjected to stirring and shearing using a high-shear stirring device. The rotational speed is preferably as fast as possible. The operating time (i.e., the time during which the device is rotating) is preferably not less than 3 minutes and not more than 4 hours, for example, the circumferential speed is preferably not less than 5 m/s and not more than 50 m/s, for example, and the temperature is preferably not lower than 15°C and not higher than 50°C, for example.

The dispersing treatment that brings about a cavitation effect is more preferably performed at a temperature of 50°C or lower. This suppresses a change in concentration due to solvent volatilization.

### ~Dispersing treatment bringing about crushing effect~

Dispersing treatment that brings about a crushing effect is even more beneficial because, in addition to of course enabling uniform dispersion of the single-walled CNTs in the solvent, dispersing treatment that brings about a crushing effect can suppress damage to the single-walled CNTs due to shock waves when air bubbles burst compared to dispersing treatment that brings about a cavitation effect described above.

The dispersing treatment that brings about a crushing effect uniformly disperses the single-walled CNTs in the solvent by causing crushing and dispersion of aggregates of the fibrous carbon nanostructures including the single-walled CNTs by imparting shear force to the crude dispersion liquid and by further applying back pressure to the crude dispersion liquid while cooling the crude dispersion liquid as necessary in order to suppress air bubble formation.

When applying back pressure to the crude dispersion liquid, although the back pressure applied to the crude dispersion liquid may be lowered at once to atmospheric pressure, the pressure is preferably lowered over multiple steps.

### -Film formation step-

In the film formation step, the solvent is removed from the fibrous carbon nanostructure dispersion liquid described above so as to form a porous self-supporting sheet. Specifically, in the film formation step, the solvent may be removed from the fibrous carbon nanostructure dispersion liquid to form a porous self-supporting sheet using either of the following methods (A) or (B), for example.
(A) A method in which the fibrous carbon nanostructure dispersion liquid is applied onto a film formation substrate and subsequently dried
(B) A method in which the fibrous carbon nanostructure dispersion liquid is filtered using a porous film formation substrate and the resultant filtration residue is dried

### [Film formation substrate]

A known substrate can be used as the film formation substrate without any specific limitations.

Specifically, the film formation substrate onto which the fibrous carbon nanostructure dispersion liquid is applied in method (A) may be a resin substrate, a glass substrate, or the like. Examples of resin substrates that can be used include substrates made from polyethylene terephthalate (PET), polyethylene naphthalate (PEN), polytetrafluoroethylene (PTFE), polyimides, polyphenylene sulfide, aramids, polypropylene, polyethylene, polylactic acid, polyvinyl chloride, polycarbonates, polymethyl methacrylate, alicyclic acrylic resins, cycloolefin resins, and triacetyl cellulose. Examples of glass substrates that can be used include a substrate made from normal soda glass.

The film formation substrate through which the fibrous carbon nanostructure dispersion liquid is filtered in method (B) may be filter paper or a porous sheet made from cellulose, nitrocellulose, alumina, or the like.

### [Application]

Application of the fibrous carbon nanostructure dispersion liquid onto the film formation substrate in method (A) can be performed by a commonly known application method. Specific examples of application methods that can be used include dipping, roll coating, gravure coating, knife coating, air knife coating, roll knife coating, die coating, screen printing, spray coating, and gravure offset.

### [Filtration]

Filtration of the fibrous carbon nanostructure dispersion liquid using the film formation substrate in method (B) can be performed by a commonly known filtration method. Specific examples of filtration methods that can be used include natural filtration, vacuum filtration, pressure filtration, and centrifugal filtration.

### [Drying]

Drying of the fibrous carbon nanostructure dispersion liquid applied onto the film formation substrate in method (A) or of the filtration residue obtained in method (B) may be performed by a commonly known drying method. Examples of drying methods that can be used include hot-air drying, vacuum drying, hot-roll drying, and infrared irradiation. Although no specific limitations are placed on the drying temperature and time, the drying temperature is normally from room temperature to 200°C and the drying time is normally from 0.1 minutes to 150 minutes.

### <After treatment of porous self-supporting sheet>

The porous self-supporting sheet formed as set forth above normally contains components of the fibrous carbon nanostructure dispersion liquid, such as single-walled CNTs, fibrous carbon nanostructures other than single-walled CNTs, and a dispersant, in the same ratio as in the fibrous carbon nanostructure dispersion liquid. In the production method of the porous self-supporting sheet, the porous self-supporting sheet that is formed in the film formation step may optionally be washed so as to remove the dispersant from the porous self-supporting sheet. Characteristics of the porous self-supporting sheet such as electrical conductivity can be further enhanced by removing the dispersant from the porous self-supporting sheet.

Washing of the porous self-supporting sheet can be performed by bringing the porous self-supporting sheet into contact with a solvent in which the dispersant is soluble so that the dispersant in the porous self-supporting sheet elutes into the solvent. The solvent in which the dispersant in the porous self-supporting sheet is soluble is not specifically limited and may be any of the previously described solvents that can be used as the solvent of the fibrous carbon nanostructure dispersion liquid. Note that it is preferable to use the same solvent as the solvent of the fibrous carbon nanostructure dispersion liquid. Contacting of the porous self-supporting sheet and the solvent can be performed by immersing the porous self-supporting sheet in the solvent or by applying the solvent onto the porous self-supporting sheet. The washed porous self-supporting sheet can then be dried by a known method.

In production of the porous self-supporting sheet, the porous self-supporting sheet that is formed in the film formation step may optionally be subjected to pressing so as to further increase the density thereof, for example, and adjust voids as necessary. However, from a viewpoint of suppressing the negative impact on characteristics due to damage or destruction of the single-walled CNTs, it is preferable that the pressing pressure is less than 3 MPa in a case in which pressing is performed, and more preferable that pressing is not performed.

Through the photoelectric conversion element 100 set forth above, functionality as a hole transport layer and functionality as a current-collecting electrode can be achieved through a single second conductive layer 8. Moreover, the second conductive layer 8 has a stable shape as a result of being formed of a porous self-supporting sheet that at least contains single-walled CNTs. Accordingly, such a configuration makes it easy to achieve enlargement of area of the photoelectric conversion element. It should be noted that so long as the presently disclosed photoelectric conversion element is a unified product of a laminate in which the order of constituent members set forth above is maintained and so long as the second conductive layer is formed of a porous self-supporting sheet containing at least single-walled CNTs, the presently disclosed photoelectric conversion element may further include other layers, etc., to the extent that the disclosed effects are not lost.

### (Production method of photoelectric conversion element)

Next, the production method of the presently disclosed photoelectric conversion element is described, referring once again to FIG. 1. The production method of the presently disclosed photoelectric conversion element 100 is required to include a step of stacking the porous self-supporting sheet on the power-generating layer 6 in a state in which a joining surface of at least one of the power-generating layer 6 and the porous self-supporting sheet retains a solvent or a solution, and optionally includes a step of heat pressing the porous self-supporting sheet that has been stacked on the power-generating layer 6. Note that the "joining surface" referred to above is a surface at a side where the power-generating layer 6 and the porous self-supporting sheet face each other. The following provides a specific description of the production method of the photoelectric conversion element 100.

### <Preparation of light-transmitting base plate 1>

In the production method of the presently disclosed photoelectric conversion element 100, the light-transmitting base plate 1 is first prepared. The type of light-transmitting base plate 1 can be as described in the "Photoelectric conversion element" section.

### <Formation of transparent conductive film 2>

Next, the transparent conductive film 2 is formed on the light-transmitting base plate 1. A commonly known method such as sputtering or vapor deposition can be adopted as the formation method of the transparent conductive film 2 without any specific limitations. Note that formation of the transparent conductive film 2 may be omitted by using a commercially available light-transmitting base plate that has a transparent conductive film formed on the surface thereof.

### <Formation of first conductive layer 5>

Next, the first conductive layer 5 is formed on the transparent conductive film 2. The first conductive layer 5 is obtained by forming the base layer 3 on the transparent conductive film 2 and subsequently forming the porous semiconductor layer 4.

### {Formation of base layer 3}

No specific limitations are placed on the method by which the base layer 3 is formed. For example, the base layer 3 can be formed by spraying a solution containing a material that forms an n-type semiconductor against the transparent conductive film 2.

The spraying method may be spray pyrolysis, aerosol deposition, electrostatic spraying, cold spraying, or the like, for example.

### {Formation of porous semiconductor layer 4}

No specific limitations are placed on the method by which the porous semiconductor layer 4 is formed. For example, the porous semiconductor layer 4 can be formed by applying a solution containing a precursor of an n-type semiconductor onto the base layer 3 by spin coating or the like and then drying the solution.

The n-type semiconductor precursor may be titanium tetrachloride (TiCl₄), peroxo titanic acid (PTA), a titanium alkoxide such as titanium ethoxide or titanium isopropoxide (TTIP), or a metal alkoxide such as zinc alkoxide, alkoxysilane, zirconium alkoxide, or titanium diisopropoxide bis(acetylacetonate).

The solvent used in the solution containing the n-type semiconductor precursor is not specifically limited and can, for example, be an alcohol solution of ethanol or the like.

Moreover, the temperature and duration of drying of the applied solution on the base layer 3 are not specifically limited and may be adjusted as appropriate depending on the type of n-type precursor and the type of solvent that are used, for example.

### <Formation of power-generating layer 6>

Next, the power-generating layer 6 is formed on the first conductive layer 5. The formation method of the power-generating layer 6 may be vacuum vapor deposition, application, or the like without any specific limitations. For example, the power-generating layer 6 can be formed by applying a precursor-containing solution containing a precursor of a perovskite compound onto the first conductive layer 5 and then performing firing thereof. The perovskite compound precursor may be lead iodide (PbI₂), methylammonium iodide (CH₃NH₃I), or the like, for example. The solvent contained in the precursor-containing solution is not specifically limited and can, for example, be N,N-dimethylformamide, dimethyl sulfoxide, or the like. After application of such a solution, precipitation of a perovskite compound can be promoted using a poor solvent. The poor solvent referred to in the present specification is a solvent in which the perovskite compound is not substantially changed in a production step. The perovskite compound can be said to be substantially unchanged in a production step when no external alteration such as film clouding is observed upon visual inspection.

The concentration of the perovskite compound precursor in the precursor-containing solution may be a concentration that is appropriate depending on the solubility of a constituent material of the perovskite compound, for example, and can be set as approximately 0.5 M to 1.5 M, for example.

A commonly known application method such as spin coating, spraying, or bar coating can be adopted as the method by which the precursor-containing solution is applied onto the first conductive layer 5 without any specific limitations.

### <Formation of second conductive layer 8>

After formation of the power-generating layer 6, the second conductive layer 8 is formed on the power-generating layer 6. In the production method of the presently disclosed photoelectric conversion element 100, the porous self-supporting sheet is stacked on the power-generating layer 6 in a state in which a joining surface of at least one of the power-generating layer 6 and the porous self-supporting sheet retains a solvent or a solution. The porous self-supporting sheet contains a constituent material of the power-generating layer or at least part of a constituent material of the power-generating layer. This enables simple production of a photoelectric conversion element 100 having excellent photoelectric conversion efficiency.

The solvent may be a poor solvent such as chlorobenzene, toluene, or anisole, for example. By using any of these poor solvents, it is possible to cause good affixing of the porous self-supporting sheet to the power-generating layer 6 in a case in which the power-generating layer 6 is a perovskite layer formed of a perovskite compound, for example.

Moreover, in a case in which the power-generating layer 6 is a perovskite layer, a solution having at least one perovskite compound precursor dissolved in a poor solvent can be used as the solution. Through this configuration, better formation of an interface of the perovskite layer and the porous self-supporting sheet is possible. This enables efficient transfer of charge between the power-generating layer 6 and the second conductive layer 8 in the obtained photoelectric conversion element 100 and, as a result, can improve the photoelectric conversion efficiency.

A solvent or a solution can be retained well at a joining surface of at least one of the power-generating layer 6 and the porous self-supporting sheet by using a porous self-supporting sheet that is impregnated with the solvent or solution described above.

A porous self-supporting sheet that is impregnated with the solvent or solution can be obtained by, for example, immersing the porous self-supporting sheet in the above-described solvent or solution and then pulling up the porous self-supporting sheet. The immersion time during this operation is not specifically limited and may be set as appropriate depending on the type of solvent or solution that is used.

In the production method of the presently disclosed photoelectric conversion element 100, the porous self-supporting sheet that has been stacked on the power-generating layer 6 is preferably heat pressed. This makes it possible to obtain a photoelectric conversion element 100 having excellent unity. The heating temperature during this heat pressing is not specifically limited and can be set as approximately 100°C, for example. Moreover, the pressure during this heat pressing is not specifically limited and can be set as 0.05 MPa, for example. Furthermore, the pressing time is not specifically limited and can be set as 30 seconds, for example. In order to promote removal of a solvent component contained in the porous self-supporting sheet during heat pressing, it is preferable that pressing is performed in a form that ensures a volatilization pathway for the solvent. Specifically, it is preferable that the heat pressing is performed through a member including voids such as a thick wipe, a porous rubber, a porous metal, or a porous ceramic, for example, in order to ensure a volatilization pathway for the solvent.

Through the production method set forth above, it is possible to efficiently produce the photoelectric conversion element 100 illustrated in FIG. 1. Note that the presently disclosed method of producing a photoelectric conversion element is not limited to the method set forth above and may include other steps besides those described above to the extent that the disclosed effects are not lost.

### (Photoelectric conversion element according to modified example)

FIG. 2 is a cross-sectional view schematically illustrating the configuration of a photoelectric conversion element according to a modified example of the embodiment of the present disclosure. The photoelectric conversion element 200 includes a unified laminate that includes, in stated order: a light-transmitting base plate 1; a transparent conductive film 2; a first conductive layer 5 including a base layer 3 and a porous semiconductor layer 4; a power-generating layer 6; a joining layer 7; and a second conductive layer 8. The joining layer 7 is a layer that is included in at least part of between the power-generating layer 6 and the second conductive layer 8 and may be included throughout the entirety of between the power-generating layer 6 and the second conductive layer 8 as illustrated in FIG. 2. The joining layer 7 is formed of an organic material A and has a different composition and property to the power-generating layer 6 and the second conductive layer 8.

Note that the photoelectric conversion element according to the example of the present disclosure is the same as the photoelectric conversion element according to the embodiment of the present disclosure set forth above with the exception that it further includes the joining layer 7. Therefore, parts that have fundamentally the same functions as in the embodiment set forth above are denoted using the same reference signs in the following description, and description thereof is omitted.

### <Joining layer 7>

The joining layer 7 is included in at least part of between the power-generating layer 6 and the second conductive layer 8 as described above. The joining layer 7 is formed of an organic material A and has a different composition and property to the power-generating layer 6 and the second conductive layer 8. The joining layer 7 is included in order to fill in irregularities at the surface of the power-generating layer 6 and/or voids formed between the power-generating layer 6 and the second conductive layer 8 due to the porous self-supporting sheet that constitutes the second conductive layer 8. The inclusion of the joining layer 7 enables good transfer of charge between the power-generating layer 6 and the second conductive layer 8 in the photoelectric conversion element 200, and thereby causes the photoelectric conversion element 200 to display excellent photoelectric conversion efficiency.

The organic material A forming the joining layer 7 may be a polymer material that displays adhesiveness such as polymethyl methacrylate (PMMA), a polymer material that displays semiconductor properties such as 2,2',7,7'-tetrakis(N,N-di-p-methoxyphenylamino)-9,9'-spirobifluorene (spiro-MeOTAD), or the like, for example. Moreover, the joining layer 7 may be formed using a mixture of any of these various materials.

The thickness of the joining layer 7 can be set as appropriate depending on the surface shape of the power-generating layer 6 and/or the second conductive layer 8, for example, without any specific limitations, so long as it fills in voids that are formed between the power-generating layer 6 and the second conductive layer 8.

The porous self-supporting sheet preferably contains a constituent material of the above-described joining layer 7. More specifically, the porous self-supporting sheet preferably contains the organic material A forming the joining layer 7 inside a plurality of pores of the porous self-supporting sheet.

Through the photoelectric conversion element 200 set forth above, functionality as a hole transport layer and functionality as a current-collecting electrode can be achieved through a single second conductive layer 8. Moreover, through the inclusion of the joining layer 7 between the power-generating layer 6 and the second conductive layer 8, voids between the power-generating layer 6 and the second conductive layer 8 are filled in, thereby enabling good transfer of charge between the power-generating layer 6 and the second conductive layer 8, and, as a result, increasing the photoelectric conversion efficiency. Furthermore, the second conductive layer 8 has a stable shape as a result of being formed of a porous self-supporting sheet that at least contains single-walled CNTs. Accordingly, such a configuration makes it easy to achieve enlargement of area of the photoelectric conversion element. It should be noted that so long as the photoelectric conversion element of the present modified example is a unified product of a laminate in which the order of constituent members set forth above is maintained, so long as the second conductive layer is formed of a porous self-supporting sheet containing at least single-walled CNTs, so long as a joining layer is included in at least part of between the power-generating layer and the second conductive layer, and so long as the joining layer is formed of an organic material A and has a different composition and property to the power-generating layer and the second conductive layer, the photoelectric conversion element of the present modified example may further include other layers, etc., to the extent that the disclosed effects are not lost.

### (Production method of photoelectric conversion element according to modified example)

Next, the production method of the photoelectric conversion element according to the modified example of the present disclosure is described, referring once again to FIG. 2. The production method of the photoelectric conversion element 200 according to the modified example of the present disclosure is required to include a step of stacking the porous self-supporting sheet on the power-generating layer 6 in a state in which a joining surface of at least one of the power-generating layer 6 and the porous self-supporting sheet retains a solvent or a solution, and optionally includes a step of heat pressing the porous self-supporting sheet that has been stacked on the power-generating layer 6. The following provides a specific description of the production method of the photoelectric conversion element 200.

In the production method of the photoelectric conversion element 200 according to the modified example of the present disclosure, preparation of the light-transmitting base plate 1, formation of the transparent conductive film 2, formation of the first conductive layer 5 (formation of the base layer 3 and formation of the porous semiconductor layer 4), formation of the power-generating layer 6, and formation of the joining layer 7 and the second conductive layer 8 are performed. Note that methods of preparation of the light-transmitting base plate 1, formation of the transparent conductive film 2, formation of the first conductive layer 5, formation of the base layer 3, formation of the porous semiconductor layer 4, and formation of the power-generating layer 6 are as described above in the "Preparation of light-transmitting base plate 1" section, the "Formation of transparent conductive film 2" section, the "Formation of first conductive layer 5" section ("Formation of base layer 3" and "Formation of porous semiconductor layer 4" sections), and the "Formation of power-generating layer 6" section, and thus description thereof is not repeated in the following description, which only describes the formation method of the joining layer 7 and the second conductive layer 8.

### <Formation of joining layer 7 and second conductive layer 8>

After formation of the power-generating layer 6, the second conductive layer 8 is formed on the power-generating layer 6 with the joining layer 7 interposed therebetween. In the production method of the photoelectric conversion element 200 according to the modified example of the present disclosure, the porous self-supporting sheet is stacked on the power-generating layer 6 in a state in which a joining surface of at least one of the power-generating layer 6 and the porous self-supporting sheet retains a solvent or a solution. This enables simple production of a photoelectric conversion element 200 having excellent photoelectric conversion efficiency.

The solvent may be any of the solvents given as examples in the "Formation of second conductive layer 8" section.

The solution may, for example, be an organic material-containing solution having the organic material A forming the joining layer 7 described above dissolved in a poor solvent.

A solvent or solution can be retained well at a joining surface of at least one of the power-generating layer 6 and the porous self-supporting sheet by using a porous self-supporting sheet that is impregnated with the solvent or the solution described above.

A porous self-supporting sheet that is impregnated with the solvent or solution can be obtained by, for example, immersing the porous self-supporting sheet in the above-described solvent or solution and then pulling up the porous self-supporting sheet. The immersion time during this operation is not specifically limited and may be set as appropriate depending on the type of solvent or solution that is used, for example.

Although no specific limitations are placed on the method by which the joining layer 7 is formed, it is preferable from a viewpoint of efficiently producing the photoelectric conversion element 200 that the porous self-supporting sheet is immersed in an organic material-containing solution having the organic material A (for example, PMMA or the like such as previously described) forming the joining layer 7 dissolved in a poor solvent, is pulled up from the organic material-containing solution, and is subsequently heated and dried so as to form the joining layer 7 on the porous self-supporting sheet, and that the porous self-supporting sheet is then affixed to the power-generating layer 6 with the joining layer 7 interposed therebetween. The immersion time, heating temperature, and drying time during these operations are not specifically limited and may be set as appropriate depending on the type of organic material-containing solution that is used, for example. The solvent in which the organic material A forming the joining layer is dissolved is preferably a poor solvent in order to prevent effects due to the solvent remaining. However, various solvents can be used as the solvent without limitation to poor solvents so long as the solvent can be dried without affecting the power-generating layer 6.

In the production method of the photoelectric conversion element 200 according to the modified example of the present disclosure, the porous self-supporting sheet that has been stacked on the power-generating layer 6 is preferably heat pressed. This makes it possible to obtain a photoelectric conversion element 200 having excellent unity. The heating time, the pressure during heat pressing, the pressing time, and so forth are not specifically limited and can be the same as the conditions of heat pressing described for the production method of the photoelectric conversion element 100.

The production method set forth above enables efficient production of the photoelectric conversion element 200 illustrated in FIG. 2. Note that the production method of the photoelectric conversion element according to the modified example of the present disclosure is not limited to the method set forth above and may include other steps besides those described above to the extent that the disclosed effects are not lost.

### EXAMPLES

The following provides a more specific description of the present disclosure based on examples. However, the present disclosure is not limited to the following examples. The following methods were used in the examples and comparative examples to measure embedding of a perovskite layer inside pores of a porous self-supporting sheet and cell performance of a produced perovskite solar cell.

### <Embedding of perovskite layer inside pores of porous self-supporting sheet>

Embedding of a perovskite layer inside pores of a porous self-supporting sheet was inspected based on the surface state of a porous self-supporting sheet affixed to a perovskite layer after the porous self-supporting sheet had been peeled off. In a case in which irregularities were formed over the entire surface of the perovskite layer in contact with the porous self-supporting sheet in microscope observation thereof, a judgment of "Yes" for embedding of the perovskite layer inside pores of the porous self-supporting sheet was made. Moreover, in a case in which irregularities were not formed over the entire surface of the perovskite layer in contact with the porous self-supporting sheet, a judgment of "No" for embedding of the perovskite layer inside pores of the porous self-supporting sheet was made.

### <Cell performance>

A solar simulator (PEC-L11 produced by Peccell Technologies Inc.) in which an AM1.5G filter was attached to a 150 W xenon lamp light source was used as a light source. The light source was adjusted to 1 sun (AM1.5G, 100 mW/cm² [Class A of JIS C8912]). A produced perovskite solar cell was connected to a source measure unit (Series 2400 SourceMeter produced by Keithley Instruments) and the following current/voltage characteristic was measured.

Output current was measured while changing bias voltage from -0.2 V to 1.0 V in 0.01 V units under 1 sun photoirradiation. The output current was measured for each voltage step by, after the voltage had been changed, integrating values from 0.1 seconds after the voltage change to 0.2 seconds after the voltage change.

The short-circuit current density (mA/cm²), open-circuit voltage (V), fill factor, and photoelectric conversion efficiency (%) were calculated from the measurement results of the current/voltage characteristic described above.

### (Example 1)

### <Production of perovskite solar cell>

A perovskite solar cell was produced as a photoelectric conversion element by the following procedure.

### {Production of light-transmitting base plate with transparent conductive film}

A conductive glass base plate (produced by Sigma-Aldrich) that included a fluorine-doped tin oxide (FTO) film formed as a transparent conductive film on the surface of a glass base plate was prepared. The conductive glass base plate was subjected to etching so as to partially remove the FTO film. In this manner, a light-transmitting base plate having a transparent conductive film formed thereon (hereinafter, referred to as a "transparent conductive film-equipped light-transmitting base plate") was obtained.

### {Formation of first conductive layer}

### -Formation of base layer-

A solution (produced by Sigma-Aldrich) of titanium diisopropoxide bis(acetylacetonate) dissolved in isopropanol was sprayed onto the surface of the FTO film of the transparent conductive film-equipped light-transmitting base plate by spray pyrolysis. In this manner, a base layer (thickness 30 nm) formed of titanium dioxide was formed on the FTO film. Next, a solution of titanium oxide paste (produced by Sigma-Aldrich) diluted with ethanol was prepared, the obtained solution was applied onto the surface of the base layer by spin coating, and 30 minutes of heat treatment was performed at a temperature of 450°C so as to form a porous semiconductor layer (thickness 120 nm) formed of titanium dioxide (TiO₂), and thereby obtain a first conductive layer.

### {Formation of power-generating layer}

An N,N-dimethylformamide (DMF) solution containing lead iodide (PbI₂) with a concentration of 1.0 M and methylammonium iodide (CH₃NH₃I) with a concentration of 1.0 M was prepared as a solution (1) containing a precursor of a perovskite compound. The obtained solution (1) was applied onto the surface of the first conductive layer by spin coating while dripping chlorobenzene onto the surface and was then subjected to 10 minutes of firing at a temperature of 100°C to form a perovskite layer (thickness 450 nm) as a power-generating layer. In this manner, a pre-pressing laminate that included the transparent conductive film-equipped light-transmitting base plate, the first conductive layer (base layer/porous semiconductor layer), and the power-generating layer (perovskite layer) in order was obtained.

### {Production of porous self-supporting sheet}

A porous self-supporting sheet containing single-walled CNTs was produced according to the following procedure.

A crude dispersion liquid containing sodium deoxycholate (DOC) as a dispersant was obtained by adding 1.0 g of carbon nanotubes (produced by Zeon Corporation; product name: ZEONANO SG101; single-walled CNTs; average diameter: 3.5 nm; G/D ratio: 2.1; convex upward t-plot without opening formation treatment) as fibrous carbon nanostructures including single-walled CNTs to 500 mL of a 2 mass% aqueous solution of DOC serving as a dispersant-containing solvent. This crude dispersion liquid was loaded into a high-pressure homogenizer (produced by Beryu Corp.; product name: BERYU SYSTEM PRO) including a multistage pressure controller (multistage pressure reducer) for applying back pressure during dispersing and was subjected to dispersing treatment at a pressure of 100 MPa. Specifically, back pressure was applied while imparting shear force to the crude dispersion liquid so as to disperse the fibrous carbon nanostructures including single-walled CNTs and thereby obtain a fibrous carbon nanostructure dispersion liquid containing single-walled CNTs. Note that the dispersing treatment was performed for 10 minutes while causing dispersion liquid flowing out from the high-pressure homogenizer to return into the high-pressure homogenizer.

A 200 mL beaker was charged with 50 g of the produced fibrous carbon nanostructure dispersion liquid containing single-walled CNTs and 50 g of distilled water so as to produce a dispersion liquid diluted by a factor of 2, and then filtration thereof was performed using a vacuum filtration device equipped with a membrane filter under conditions of 0.09 MPa. Once the filtration was complete, isopropyl alcohol and water were each passed through the vacuum filtration device so as to wash a carbon film that had been formed on the membrane filter, and then air was passed for 15 minutes. Next, the produced carbon film/membrane filter was immersed in ethanol, and the carbon film was peeled from the membrane filter to obtain a carbon film (A).

The obtained carbon film (A) was of equivalent size to the membrane filter, had excellent film formation properties, and had excellent self-support properties such that it maintained the state of a film even after peeling from the filter. The obtained carbon film (A) was determined to have a density of 0.85 g/cm³ as a result of measurement of film density of the carbon film (A). Through these results, the carbon film (A) was confirmed to be a porous self-supporting sheet (A).

### {Formation of second conductive layer}

The porous self-supporting sheet (A) was immersed for 10 seconds in chlorobenzene and was subsequently pulled up from the chlorobenzene so as to obtain a porous self-supporting sheet (1) that was impregnated with chlorobenzene. The porous self-supporting sheet (1) was stacked on the pre-pressing laminate while the pre-pressing laminate was being heated on a hot plate having a temperature of 100°C, and then pressing (heat pressing) was performed from the porous self-supporting sheet (1) side of the resultant laminate with a pressure of 0.05 Pa so as to obtain a perovskite solar cell including a unified laminate. The obtained perovskite solar cell was used to evaluate and measure "embedding of a perovskite layer inside pores of a porous self-supporting sheet" and "cell performance". The results are shown in Table 1.

### (Example 2)

In order to perform pre-treatment of a porous self-supporting sheet, the porous self-supporting sheet (A) produced in Example 1 was immersed for 10 seconds in the solution (1) containing a precursor of a perovskite compound that was prepared in Example 1, was pulled up from the solution (1), and excess solution was removed, and then chlorobenzene was dripped onto the surface of the porous self-supporting sheet (A) impregnated with the solution (1) and was dried at a temperature of 80°C for 10 minutes to obtain a porous self-supporting sheet (2) having a perovskite compound attached thereto. The obtained porous self-supporting sheet (2) was immersed in chlorobenzene in the same way as in Example 1 to obtain a porous self-supporting sheet (2) that was impregnated with chlorobenzene. Operations were then performed in the same way as in Example 1 to obtain a perovskite solar cell with the exception that the porous self-supporting sheet (2) impregnated with chlorobenzene was stacked on the pre-pressing laminate instead of stacking the porous self-supporting sheet (1) impregnated with chlorobenzene. The obtained perovskite solar cell was used to perform various evaluations and measurements in the same way as in Example 1. The results are shown in Table 1.

### (Example 3)

An ethanol solution containing methylammonium iodide (CH₃NH₃I) with a concentration of 0.1 M was prepared as a solution (3).

In order to perform pre-treatment of a porous self-supporting sheet, the porous self-supporting sheet (A) produced in Example 1 was immersed for 10 seconds in the solution (3), was pulled up from the solution (3), and was subsequently dried at a temperature of 80°C for 10 minutes to obtain a porous self-supporting sheet (3) having methylammonium iodide attached thereto. The obtained porous self-supporting sheet (3) was immersed in chlorobenzene in the same way as in Example 1 to obtain a porous self-supporting sheet (3) that was impregnated with chlorobenzene. Operations were then performed in the same way as in Example 1 to obtain a perovskite solar cell with the exception that the porous self-supporting sheet (3) impregnated with chlorobenzene and having methylammonium iodide (MAI) attached thereto was stacked on the pre-pressing laminate instead of stacking the porous self-supporting sheet (1) impregnated with chlorobenzene. The obtained perovskite solar cell was used to perform various evaluations and measurements in the same way as in Example 1. The results are shown in Table 1.

### (Example 4)

A chlorobenzene solution containing methylammonium iodide (CH₃NH₃I) with a concentration of 1.0 M was prepared as a solution (4). The porous self-supporting sheet (A) produced in Example 1 was immersed for 10 seconds in the solution (4) and was pulled up from the solution (4) to obtain a porous self-supporting sheet (4) that was impregnated with the solution (4). Operations were then performed in the same way as in Example 1 to obtain a perovskite solar cell with the exception that the porous self-supporting sheet (4) impregnated with the solution (4) was stacked on the pre-pressing laminate instead of stacking the porous self-supporting sheet (1) impregnated with chlorobenzene. The obtained perovskite solar cell was used to perform various evaluations and measurements in the same way as in Example 1. The results are shown in Table 1.

### (Example 5)

Operations were performed in the same way as in Example 1 to obtain a perovskite solar cell with the exception that a porous self-supporting sheet (B) having a thickness of 1 µm that was produced by the same method as in Example 1 was used instead of the porous self-supporting sheet (A) produced in Example 1. The obtained perovskite solar cell was used to perform various evaluations and measurements in the same way as in Example 1. The results are shown in Table 1.

### (Comparative Example 1)

Operations were performed in the same way as in Example 1 so as to attempt to produce a perovskite solar cell with the exception that a sheet (C) having a thickness of 0.1 µm that was produced by the same method as in Example 1 was used as a sheet other than a porous self-supporting sheet instead of using the porous self-supporting sheet (A) produced in Example 1. However, it was not possible to produce a perovskite solar cell because tearing of the sheet (C) occurred upon immersion thereof in chlorobenzene.

### (Comparative Example 2)

Operations were performed in the same way as in Example 1 so as to attempt to produce a perovskite solar cell with the exception that the porous self-supporting sheet (A) that was not impregnated with chlorobenzene was stacked on the pre-pressing laminate instead of stacking the porous self-supporting sheet (1) that was impregnated with chlorobenzene. However, it was not possible to obtain a perovskite solar cell because the porous self-supporting sheet (A) could not be affixed to and unified with the power-generating layer of the pre-pressing laminate.

**Table 1**

| | | | | Example 1 | Example 2 | Example 3 | Example 4 | Example 5 | Comparative Example 1 | Comparative Example 2 |
|---|---|---|---|---|---|---|---|---|---|---|
| Configuration | Light-transmitting base plate | | Type | Glass | Glass | Glass | Glass | Glass | Glass | Glass |
| | Transparent conductive film | | Type | FTO | FTO | FTO | FTO | FTO | FTO | FTO |
| | First conductive layer | Base layer | Type | TiO₂ dense layer | TiO₂ dense layer | TiO₂ dense layer | TiO₂ dense layer | TiO₂ dense layer | TiO₂ dense layer | TiO₂ dense layer |
| | | Porous semiconductor layer | Type | TiO₂ porous layer | TiO₂ porous layer | TiO₂ porous layer | TiO₂ porous layer | TiO₂ porous layer | TiO₂ porous layer | TiO₂ porous layer |
| | Power-gererating layer | | Type | MAPbI₃ | MAPbI₃ | MAPbI₃ | MAPbI₃ | MAPbI₃ | MAPbI₃ | MAPbI₃ |
| | Second conductive layer | Porous self-supporting sheet | Type | Single-walled CNT film | Single-walled CNT film (perovskite compound attached) | Single-walled CNT film (MAI attached) | Single-walled CNT film | Single-walked CNT film | - | Single-walked CNT film |
| | | | Thickness [µm] | 50 | 50 | 50 | 50 | 1 | - | 50 |
| | | Sheet other than porous self-supporting sheet | Type | - | - | - | - | - | Single-walled CNT film | - |
| | | | Thickness [µm] | - | - | - | - | - | 0.1 | - |
| Production steps | Pre-treatment of porous self-supporting sheet | | | No | Yes | Yes | No | No | No | No |
| | Solvent or solution used in immersion of porous self-supporting sheet or sheet other than porous self-supporting sheet | | Type | CB | CB | CB | MAI/CB | CB | CB | - |
| | Heat pressing | | | Yes | Yes | Yes | Yes | Yes | - | Yes |
| Evaluation | Short-circuit current density [mA/cm²] | | | 11.260 | 6.663 | 8.137 | 7.562 | 10.356 | - | - |
| | Open-circuit voltage [V] | | | 0.852 | 0.811 | 0.922 | 0.895 | 0.842 | - | - |
| | Fill factor | | | 0.585 | 0.672 | 0.552 | 0.511 | 0.246 | - | - |
| | Photoelectric conversion efficiency [%] | | | 5.61 | 3.63 | 4.14 | 3.46 | 2.14 | - | - |
| | Embedding of perovskite layer inside pores of porous self-supporting sheet | | | Yes | Yes | Yes | Yes | Yes | - | No |

### (Example 6, not forming part of the claimed invention)

Operations were performed in the same way as in Example 1 to obtain a transparent conductive film-equipped light-transmitting base plate, a first conductive layer (base layer/porous semiconductor layer), a power-generating layer, and a porous self-supporting sheet.

### {Formation of joining layer}

A solution (10) containing polymethyl methacrylate (hereinafter, referred to as "PMMA") and chlorobenzene was prepared as an organic material-containing solution.

In order to perform pre-treatment of the porous self-supporting sheet, the porous self-supporting sheet (A) was immersed for 30 seconds in the solution (10) obtained as described above, was pulled up from the solution (10), and was subsequently dried at a temperature of 80°C for 2 minutes to obtain a porous self-supporting sheet (10) having a layer (joining layer) formed of PMMA formed thereon.

### {Formation of second conductive layer}

The porous self-supporting sheet (10) was immersed for 10 seconds in chlorobenzene and was then pulled up from the chlorobenzene to obtain a porous self-supporting sheet (10) that was impregnated with chlorobenzene. The porous self-supporting sheet (10) was stacked on the pre-pressing laminate such that the power-generating layer and the layer (joining layer) formed of PMMA were facing while the pre-pressing laminate was being heated on a hot plate having a temperature of 100°C, and then pressing (heat pressing) was performed from the porous self-supporting sheet (10) side with a pressure of 0.05 MPa to obtain a perovskite solar cell. The obtained perovskite solar cell was used to measure cell performance. The results are shown in Table 2.

### (Example 7, not forming part of the claimed invention)

A solution (20) containing PMMA and anisole was prepared as an organic material-containing solution.

In order to perform pre-treatment of a porous self-supporting sheet, the porous self-supporting sheet (A) was immersed for 30 seconds in the solution (20) obtained as described above, was pulled up from the solution (20), and was subsequently dried at a temperature of 80°C for 2 minutes to obtain a porous self-supporting sheet (20) having a layer (joining layer) formed of PMMA formed thereon. The obtained porous self-supporting sheet (20) was immersed in chlorobenzene in the same way as in Example 6 to obtain a porous self-supporting sheet (20) that was impregnated with chlorobenzene. Heat pressing was then performed in the same way as in Example 6 to obtain a perovskite solar cell with the exception that the porous self-supporting sheet (20) impregnated with chlorobenzene was stacked on the pre-pressing laminate instead of stacking the porous self-supporting sheet (10) impregnated with chlorobenzene. The obtained perovskite solar cell was used to perform measurements in the same way as in Example 6. The results are shown in Table 2.

### (Example 8, not forming part of the claimed invention)

A solution (30) containing PMMA and chlorobenzene was prepared as an organic material-containing solution.

The porous self-supporting sheet (A) was immersed for 30 seconds in the solution (30) obtained as described above to obtain a porous self-supporting sheet (30) that was impregnated with the solution (30). Heat pressing was then performed in the same way as in Example 6 to form a layer (joining layer) formed of PMMA between the power-generating layer and the porous self-supporting sheet (30) and to obtain a perovskite solar cell with the exception that the porous self-supporting sheet (30) impregnated with the solution (30) was stacked on the pre-pressing laminate while the pre-pressing laminate was being heated on a hot plate having a temperature of 100°C. The obtained perovskite solar cell was used to perform measurements in the same way as in Example 6. The results are shown in Table 2.

### (Example 9, not forming part of the claimed invention)

A porous self-supporting sheet (B) having a thickness of 1 µm that was produced by the same method as in Example 6 was used instead of the porous self-supporting sheet (A) produced in Example 6.

The obtained porous self-supporting sheet (B) was then used to perform operations in the same way as in Example 6 so as to obtain a porous self-supporting sheet (40) having a layer (joining layer) formed of PMMA formed thereon.

The porous self-supporting sheet (40) was stacked on the pre-pressing laminate such that the power-generating layer and the layer (joining layer) formed of PMMA were facing while the pre-pressing laminate was being heated on a hot plate having a temperature of 100°C, chlorobenzene was dripped onto the surface of the porous self-supporting sheet (40), and then heat pressing was performed in the same way as in Example 6 to obtain a perovskite solar cell. The obtained perovskite solar cell was used to perform measurements in the same way as in Example 6. The results are shown in Table 2.

### (Comparative Example 3)

A sheet (C) having a thickness of 0.1 µm that was produced by the same method as in Example 9 was used as a sheet other than a porous self-supporting sheet instead of using the porous self-supporting sheet (B) produced in Example 9. Production of a perovskite solar cell was attempted in the same way as in Example 9, but tearing of the sheet (C) occurred when the sheet (C) was immersed in the solution (10) to perform pre-treatment of the sheet (C). Consequently, it was not possible to produce a perovskite solar cell.

### (Comparative Example 4)

Production of a perovskite solar cell was attempted in the same way as in Example 6 with the exception that the porous self-supporting sheet (10) was not immersed in chlorobenzene and thus a porous self-supporting sheet (10) that was not impregnated with chlorobenzene was stacked on the pre-pressing laminate. However, it was not possible to obtain a perovskite solar cell because the porous self-supporting sheet (A) could not be affixed to the pre-pressing laminate.

**Table 2**

| | | | | Example 6 | Example 7 | Example 8 | Example 9 | Comparative Example 3 | Comparative Example 4 |
|---|---|---|---|---|---|---|---|---|---|
| Configuration | Light-transmitting base plate | | Type | Glass | Glass | Glass | Glass | Glass | Glass |
| | Transparent conductive film | | Type | FTO | FTO | FTO | FTO | FTO | FTO |
| | First conductive layer | Base layer | Type | TiO₂ dense layer | TiO₂ dense layer | TiO₂ dense layer | TiO₂ dense layer | TiO₂ dense layer | TiO₂ dense layer |
| | | Porous semiconductor layer | Type | TiO₂ porous layer | TiO₂ porous layer | TiO₂ porous layer | TiO₂ porous layer | TiO₂ porous layer | TiO₂ porous layer |
| | Power-generating layer | | Type | MAPbI₃ | MAPbI₃ | MAPbI₃ | MAPbI₃ | MAPbI₃ | MAPbI₃ |
| | Second conductive layer | Porous self-supporting sheet | Type | Single-walled CNT film | Single-walled CNT film | Single-walled CNT film | Single-walled CNT film | | Single-walled CNT film |
| | | | Thickness [µm] | 50 | 50 | 50 | 1 | - | 50 |
| | | Sheet other than porous self-supporting sheet | Type | - | - | - | - | Single-walled CNT film | - |
| | | | Thickness [µm] | - | - | - | - | 0.1 | - |
| Production steps | Pre-treatment of porous self-supporting sheet | | | Yes | Yes | No | Yes | Yes | No |
| | Solvent or solution used in immersion of porous self-supporting sheet or sheet other than porous self-supporting sheet | | Type | CB | CB | PMMA/CB | CB | CB | - |
| | Heat pressing | | | Yes | Yes | Yes | Yes | - | Yes |
| Evaluation | Short-circuit current density [mA/cm²] | | | 11.072 | 12.756 | 8.562 | 11.523 | - | - |
| | Open-circuit voltage [V] | | | 0.929 | 0.929 | 0.901 | 0.921 | - | - |
| | Fill factor | | | 0.428 | 0.481 | 0.408 | 0.236 | - | - |
| | Photoelectric conversion efficiency [%] | | | 4.40 | 5.70 | 3.15 | 2.50 | - | - |

| | | | | | | | | | |
|---|---|---|---|---|---|---|---|---|---|
| In Tables 1 and 2: "FTO" indicates fluorine-doped tin oxide; "MAI" indicates methylammonium iodide; "CB" indicates chlorobenzene; and "PMMA" indicates polymethyl methacrylate. | | | | | | | | | |

It can be seen from the results in Tables 1 and 2 that a perovskite solar cell having excellent photoelectric conversion efficiency can be produced through the methods of Examples 1 to 9.

### INDUSTRIAL APPLICABILITY

According to the present disclosure, it is possible to provide a photoelectric conversion element that displays excellent photoelectric conversion efficiency and is easy to produce and a method of producing this photoelectric conversion element.

### REFERENCE SIGNS LIST

- 1: light-transmitting base plate
- 2: transparent conductive film
- 3: base layer
- 4: porous semiconductor layer
- 5: first conductive layer
- 6: power-generating layer
- 7: joining layer
- 8: second conductive layer (porous self-supporting sheet)
- 100, 200: photoelectric conversion element

## Claims

1. A photoelectric conversion element (100) comprising a unified laminate that includes, in stated order, a light-transmitting base plate (1), a transparent conductive film (2), a first conductive layer (5), a power-generating layer (6), and a second conductive layer (8), wherein
the second conductive layer (8) is formed of a porous self-supporting sheet that at least contains one or more single-walled carbon nanotubes, and
the porous self-supporting sheet contains a constituent material of the power-generating layer (6) or at least part of a constituent material of the power-generating layer (6).

2. The photoelectric conversion element (100) according to claim 1, wherein
a joining layer is included in at least part of between the power-generating layer (6) and the second conductive layer (8), and
the joining layer is formed of an organic material A and has a different composition and property than the power-generating layer (6) and the second conductive layer (8).

3. The photoelectric conversion element (100) according to claim 2, wherein the porous self-supporting sheet contains the organic material A.

4. The photoelectric conversion element (100) according to any one of claims 1 to 3, wherein the porous self-supporting sheet has a thickness of 20 µm or more.

5. The photoelectric conversion element (100) according to any one of claims 1 to 4, wherein the power-generating layer (6) contains a perovskite compound.

6. The photoelectric conversion element (100) according to any one of claims 1 to 5, wherein the single-walled carbon nanotubes have an average diameter (Av) and a diameter standard deviation (σ) satisfying a relationship: 0.20 < (3σ/Av) < 0.60.

7. The photoelectric conversion element (100) according to any one of claims 1 to 6, wherein the single-walled carbon nanotubes exhibit a convex upward shape in a t-plot obtained from an adsorption isotherm measured as described in the description.

8. The photoelectric conversion element (100) according to any one of claims 1 to7, wherein the first conductive layer (5) contains either or both of a metal oxide and an organic compound.

9. A method of producing a photoelectric conversion element (100) that is a method of producing the photoelectric conversion element (100) according to any one of claims 1 to 8, comprising a step of stacking the porous self-supporting sheet on the power-generating layer (6) in a state in which a joining surface of at least one of the power-generating layer (6) and the porous self-supporting sheet retains a solvent or a solution.

10. The method of producing a photoelectric conversion element (100) according to claim 9, wherein
the solvent is a poor solvent, and
the porous self-supporting sheet that is stacked on the power-generating layer (6) is impregnated with the solvent.

11. A method of producing a photoelectric conversion element (100) that is a method of producing the photoelectric conversion element (100) according to any one of claims 1 and 4 to 8, comprising a step of stacking the porous self-supporting sheet on the power-generating layer (6) in a state in which a joining surface of at least one of the power-generating layer (6) and the porous self-supporting sheet retains a solvent or a solution, wherein
the power-generating layer (6) is a layer that is formed of a perovskite compound,
the solution is a solution having at least one perovskite compound precursor dissolved in a poor solvent, and
the porous self-supporting sheet that is stacked on the power-generating layer (6) is impregnated with the solution.

12. A method of producing a photoelectric conversion element (100) that is a method of producing the photoelectric conversion element (100) according to any one of claims 2 to 4 and 5 to 8, comprising a step of stacking the porous self-supporting sheet on the power-generating layer (6) in a state in which a joining surface of at least one of the power-generating layer (6) and the porous self-supporting sheet retains a solvent or a solution, wherein
the solution is an organic material-containing solution having the organic material A dissolved in a poor solvent, and
the porous self-supporting sheet that is stacked on the power-generating layer (6) is impregnated with the organic material-containing solution.

13. The method of producing a photoelectric conversion element (100) according to any one of claims 9 to 12, further comprising a step of heat pressing the porous self-supporting sheet that has been stacked on the power-generating layer (6).

## Patentansprüche

1. Ein photoelektrisches Umwandlungselement (100) umfassend ein einheitliches Laminat, welches in der angegebenen Reihenfolge eine lichtdurchlässige Grundplatte (1), eine transparente leitfähige Folie (2), eine erste leitfähige Schicht (5), eine stromerzeugende Schicht (6) und eine zweite leitfähige Schicht (8) beinhaltet, wobei
die zweite leitfähige Schicht (8) aus einem porösen, selbsttragenden Blatt gebildet ist, das mindestens eine oder mehrere einwandige Kohlenstoffnanoröhren enthält, und
das poröse, selbsttragende Blatt ein Bestandteilmaterial der stromerzeugenden Schicht (6) oder zumindest einen Teil eines Bestandteilmaterials der stromerzeugenden Schicht (6) enthält.

2. Das photoelektrische Umwandlungselement (100) nach Anspruch 1, wobei
eine Verbindungsschicht in zumindest einem Teil von zwischen der stromerzeugenden Schicht (6) und der zweiten leitfähigen Schicht (8) vorgesehen ist, und
die Verbindungsschicht aus einem organischen Material A gebildet ist und eine andere Zusammensetzung und Eigenschaft aufweist als die stromerzeugende Schicht (6) und die zweite leitfähige Schicht (8).

3. Das photoelektrische Umwandlungselement (100) nach Anspruch 2, wobei das poröse, selbsttragende Blatt das organische Material A enthält.

4. Das photoelektrische Umwandlungselement (100) nach einem der Ansprüche 1 bis 3, wobei das poröse, selbsttragende Blatt eine Dicke von 20µm oder mehr aufweist.

5. Das photoelektrische Umwandlungselement (100) nach einem der Ansprüche 1 bis 4, wobei die stromerzeugende Schicht (6) eine Perowskitverbindung enthält.

6. Das photoelektrische Umwandlungselement (100) nach einem der Ansprüche 1 bis 5, wobei die einwandigen Kohlenstoffnanoröhren einen mittleren Durchmesser (Av) und eine Durchmesser-Standardabweichung (σ) haben, die ein Verhältnis: 0,20 < (3σ/Av) < 0,60 erfüllen.

7. Das photoelektrische Umwandlungselement (100) nach einem der Ansprüche 1 bis 6, wobei die einwandigen Kohlenstoffnanoröhren eine konvexe Aufwärtsform in einem aus einer wie in der Beschreibung beschrieben gemessenen Adsorptionsisotherme erhaltenen t-Diagramm aufweisen.

8. Das photoelektrische Umwandlungselement (100) nach einem der Ansprüche 1 bis 7, wobei die erste leitfähige Schicht (5) entweder ein Metalloxid oder eine organische Verbindung oder beides enthält.

9. Verfahren zur Herstellung eines photoelektrischen Umwandlungselements (100), das ein Verfahren zur Herstellung des photoelektrischen Umwandlungselements (100) nach einem der Ansprüche 1 bis 8 ist, umfassend einen Schritt des Aufbringens des porösen, selbsttragenden Blatts auf die stromerzeugende Schicht (6) in einem Zustand, in dem eine Verbindungsfläche von mindestens einer der stromerzeugenden Schicht (6) und des porösen, selbsttragenden Blatts ein Lösungsmittel oder eine Lösung hält.

10. Verfahren zur Herstellung eines photoelektrischen Umwandlungselements (100) nach Anspruch 9, wobei
das Lösungsmittel ein schlechtes Lösungsmittel ist und
das poröse, selbsttragende Blatt, das auf die stromerzeugende Schicht (6) aufgebracht wird, mit dem Lösungsmittel imprägniert ist.

11. Verfahren zur Herstellung eines photoelektrischen Umwandlungselements (100), das ein Verfahren zur Herstellung des photoelektrischen Umwandlungselements (100) nach einem der Ansprüche 1 und 4 bis 8 ist, umfassend einen Schritt des Aufbringens des porösen, selbsttragenden Blatts auf die stromerzeugende Schicht (6) in einem Zustand, in dem eine Verbindungsfläche von mindestens einer der stromerzeugenden Schicht (6) und des porösen, selbsttragenden Blatts ein Lösungsmittel oder eine Lösung hält, wobei
die stromerzeugende Schicht (6) eine Schicht ist, die aus einer Perowskitverbindung gebildet ist,
die Lösung eine Lösung ist, die mindestens einen Perowskit-Verbindungsvorläufer in einem schlechten Lösungsmittel gelöst aufweist, und
das poröse, selbsttragende Blatt, das auf die stromerzeugende Schicht (6) aufgebracht wird, mit der Lösung imprägniert ist.

12. Verfahren zur Herstellung eines photoelektrischen Umwandlungselements (100), das ein Verfahren zur Herstellung des photoelektrischen Umwandlungselements (100) nach einem der Ansprüche 2 bis 4 und 5 bis 8 ist, umfassend einen Schritt des Aufbringens des porösen, selbsttragenden Blatts auf die stromerzeugende Schicht (6) in einem Zustand, in dem eine Verbindungsfläche von mindestens einer der stromerzeugenden Schicht (6) und des porösen, selbsttragenden Blatts ein Lösungsmittel oder eine Lösung hält, wobei
die Lösung eine organisches Material enthaltende Lösung ist, die die organische Substanz in einem schlechten Lösungsmittel gelöst aufweist, und
das poröse, selbsttragende Blatt, das auf die stromerzeugende Schicht (6) aufgebracht wird, mit der organisches Material enthaltenden Lösung imprägniert ist.

13. Verfahren zur Herstellung eines photoelektrischen Umwandlungselements (100)
nach einem der Ansprüche 9 bis 12, ferner umfassend einen Schritt des Heißpressens des porösen, selbsttragenden Blatts, das auf die stromerzeugende Schicht (6) aufgebracht wurde.

## Revendications

1. Élément de conversion photoélectrique (100) comprenant un stratifié unifié qui inclut, dans l'ordre indiqué, une plaque de base transmettant la lumière (1), un film conducteur transparent (2), une première couche conductrice (5), une couche génératrice d'électricité (6), et une seconde couche conductrice (8), dans lequel
la seconde couche conductrice (8) est formée d'une feuille autoportante poreuse qui contient au moins 1 nou plusieurs nanotubes de carbone à paroi simple, et
la feuille autoportante poreuse contient un matériau constitutif de la couche génératrice d'électricité (6) ou au moins une partie d'un matériau constitutif de la couche génératrice d'électricité (6).

2. Élément de conversion photoélectrique (100) selon la revendication 1, dans lequel
une couche de jonction est incluse au moins en partie entre la couche génératrice d'électricité (6) et la seconde couche conductrice (8), et
la couche de jonction est formée d'un matériau organique A et présente une composition et une propriété différentes de celles de la couche génératrice d'électricité (6) et de la seconde couche conductrice (8).

3. Élément de conversion photoélectrique (100) selon la revendication 2, dans lequel la feuille autoportante poreuse contient le matériau organique A.

4. Élément de conversion photoélectrique (100) selon l'une quelconque des revendications 1 à 3, dans lequel la feuille autoportante poreuse présente une épaisseur de 20 µm ou plus.
NF:MY

5. Élément de conversion photoélectrique (100) selon l'une quelconque des revendications 1 à 4, dans lequel la couche génératrice d'électricité (6) contient un composé de pérovskite.

6. Élément de conversion photoélectrique (100) selon l'une quelconque des revendications 1 à 5, dans lequel les nanotubes de carbone à paroi simple présentent un diamètre moyen (Av) et un écart type du diamètre (o) satisfaisant la relation : 0,20 < (30/Av) < 0,60.

7. Élément de conversion photoélectrique (100) selon l'une quelconque des revendications 1 à 6, dans lequel les nanotubes de carbone à paroi simple présentent une forme convexe vers le haut dans un t-plot obtenu à partir d'une isotherme d'adsorption mesurée comme décrit dans la description.

8. Élément de conversion photoélectrique (100) selon l'une quelconque des revendications 1 à 7, dans lequel la première couche conductrice (5) contient l'un ou les deux d'un oxyde métallique et d'un composé organique.

9. Procédé de production d'un élément de conversion photoélectrique (100) qui est un procédé de production de l'élément de conversion photoélectrique (100) selon l'une quelconque des revendications 1 à 8, comprenant une étape d'empilement de la feuille autoportante poreuse sur la couche génératrice d'électricité (6) dans un état dans lequel une surface de jonction d'au moins l'une de la couche génératrice d'électricité (6) et de la feuille autoportante poreuse retient un solvant ou une solution.

10. Procédé de production d'un élément de conversion photoélectrique (100) selon la revendication 9, dans lequel
le solvant est un mauvais solvant, et
la feuille autoportante poreuse qui est empilée sur la couche génératrice d'électricité (6) est imprégnée du solvant.

11. Procédé de production d'un élément de conversion photoélectrique (100) qui est un procédé de production de l'élément de conversion photoélectrique (100) selon l'une quelconque des revendications 1 et 4 à 8, comprenant une étape d'empilement de la feuille autoportante poreuse sur la couche génératrice d'électricité (6) dans un état dans lequel une surface de jonction d'au moins l'une de la couche génératrice d'électricité (6) et de la feuille autoportante poreuse retient un solvant ou une solution, dans lequel
la couche génératrice d'électricité (6) est une couche qui est formée d'un composé de pérovskite,
la solution 3s tune solution ayant au moins un précurseur de composé de pérovskite dissous dans un mauvais solvant, et
la feuille autoportante poreuse qui est empilée sur la couche génératrice d'électricité (6) est imprégnée de la solution.

12. Procédé de production d'un élément de conversion photoélectrique (100) qui est un procédé de production de l'élément de conversion photoélectrique (100) selon l'une quelconque des revendications 2 à 4 et 5 à 8, comprenant une étape d'empilement de la feuille autoportante poreuse sur la couche génératrice d'électricité (6) dans un état dans lequel une surface de jonction d'au moins l'une de la couche génératrice d'électricité (6) et de la feuille autoportante poreuse retient un solvant ou une solution, dans lequel
la solution est une solution contenant un matériau organique ayant le matériau organique A dissous dans un mauvais solvant, et
la feuille autoportante poreuse qui est empilée sur la couche génératrice d'électricité (6) est imprégnée de la solution contenant un matériau organique.

13. Procédé de production d'un élément de conversion photoélectrique (100) selon l'une quelconque des revendications 9 à 12, comprenant en outre une étape de pressage à chaud de la feuille autoportante poreuse qui a été empilée sur la couche génératrice d'électricité (6).
